Europäisches Patentamt

European Patent Office

Office européen des brevets

(19)

(11) Veröffentlichungsnummer: **0 094 712**
**B1**

(12) **EUROPÄISCHE PATENTSCHRIFT**

(45) Veröffentlichungstag der Patentschrift:
19.02.86

(21) Anmeldenummer: 83200654.8

(22) Anmeldetag: 06.05.83

(51) Int. Cl.⁴: **H 01 L 41/08,** G 11 B 21/10,
G 11 B 5/56

(54) Schaltungsanordnung zur Erzeugung einer Steuerspannung für ein piezoelektrisches Element einer Positionierungseinrichtung.

(30) Priorität: 13.05.82 AT 1887/82

(43) Veröffentlichungstag der Anmeldung:
23.11.83 Patentblatt 83/47

(45) Bekanntmachung des Hinweises auf die Patenterteilung:
19.02.86 Patentblatt 86/8

(84) Benannte Vertragsstaaten:
AT DE FR GB IT

(56) Entgegenhaltungen:
FR - A - 2 345 779
GB - A - 1 259 576
GB - A - 2 022 901
GB - A - 2 072 889
US - A - 3 551 764

PATENTS ABSTRACTS OF JAPAN, Band 6, Nr. 92, 29.
Mai 1982, Seite (P-119)970i

(73) Patentinhaber: N.V. Philips' Gloeilampenfabrieken,
Groenewoudseweg 1, NL-5621 BA Eindhoven (NL)

(72) Erfinder: Süss, Dietfried, c/o INT. OCTROOIBUREAU
B.V. Prof. Holstlaan 6, NL-5656 AA Eindhoven (NL)

(74) Vertreter: van der Kruk, Willem Leonardus et al,
INTERNATIONAAL OCTROOIBUREAU B.V. Prof.
Holstlaan 6, NL-5656 AA Eindhoven (NL)

Beschreibung

Die Erfindung betrifft eine Schaltungsanordnung zur Erzeugung einer Steuerspannung für ein piezoelektrisches Element einer Positionierungseinrichtung, die insbesondere zur Positionierung eines Aufzeichnungs- und/oder Wiedergabekopfes in bezug auf eine Informationsspur vorgesehen ist, bei welcher ein eine Fehlposition widerspiegelndes Regelsignal einer Signalwandlerstufe zugeführt wird, deren Ausgangssignal an den Primärkreis eines Transformators angelegt wird, an dessen Sekundärkreis das piezoelektrische Element über eine bipolare Schalteinrichtung angeschlossen ist, die ihrerseits in vorgegebener Relation zum Ausgangssignal der Signalwandlerstufe mit einem Schaltsignal angesteuert wird. Eine solche Schaltungsanordnung ist aus der AT-PS Nr. 364548 bekannt.

Ein piezoelektrisches Element, das für Positionierungszwecke eines Gegenstandes verwendet wird, benötigt für seine Auslenkung eine relativ hohe Steuerspannung, die aus einem Regelsignal zu gewinnen ist, wobei unter einem Regelsignal ganz allgemein Signale verstanden werden sollen, die in irgendeiner Form Informationen über die mit der Positionierungseinrichtung auszugleichenden Positionsfehler des Gegenstandes enthalten. An eine Schaltungsanordnung zur Erzeugung einer solchen Steuerspannung besteht dabei die Anforderung, dass diese entsprechend hohe Steuerspannung mit möglichst geringem Energiebedarf, also bei gutem Wirkungsgrad, erzeugt wird. Bei der aus der vorgenannten AT-PS Nr. 364548 bekannten Schaltungsanordnung ist hierzu vorgesehen, dass ein Regelsignal, welches hier aus zwei gleichzeitig auftretenden Signalkomponenten besteht, deren jeweiliger Phasenunterschied die Fehlposition widerspiegelt, in der Signalwandlerstufe in Impulse umgewandelt wird, die dem Primärkreis eines Transformators zugeführt werden, an dessen Sekundärkreis das piezoelektrische Element über eine bipolare Schalteinrichtung angeschlossen ist, wobei diese Impulse gleichzeitig auch als Schaltsignal zum Ansteuern der Schalteinrichtung dienen. Auf diese Weise wird jedesmal beim Auftreten eines Impulses, während dessen Dauer der Primärseite des Transformators Energie zugeführt, was primärseitig eine Spannung zur Folge hat, die auf den Sekundärkreis in eine entsprechend hohe Spannung transformiert und mit der Schalteinrichtung, während der gleichen, durch die Impulse bestimmten Dauer dem piezoelektrischen Element zugeführt wird, wodurch sich die Spannung an demselben entsprechend dem Regelsignal ändert. Die Regelinformation zur Positionierung ist dabei in der Häufigkeit des Auftretens der Impulse und deren Impulsdauer enthalten. Eine Signalwandlerstufe, die ein dementsprechendes Regelsignal in der hier erwähnten Art und Weise in Impulse umwandelt, ist in ihrem Aufbau relativ aufwendig und die im Transformator erfolgende Transformation der impulsförmigen Signale erfolgt nicht mit entsprechend gutem Wirkungsgrad.

Die Erfindung hat sich zum Ziel gesetzt, eine Schaltungsanordnung der eingangs angeführten Gattung hinsichtlich ihres Aufbaues weiter zu vereinfachen und die Erzeugung der Steuerspannung mit möglichst geringem Energieverbrauch, also bei gutem Wirkungsgrad, vorzunehmen. Die Erfindung ist hierzu dadurch gekennzeichnet, dass die Signalwandlerstufe als Amplitudenmodulator ausgebildet ist, dem einerseits das eine Fehlposition in seiner Amplitude widerspiegelnde Regelsignal und andererseits von einem Oszillator her ein gegenüber dem Regelsignal höherfrequentes periodisches Trägersignal zugeführt wird, und dass von diesem Trägersignal über eine Impulserzeugerstufe ein periodisches, impulsförmiges, zeitlich jeweils korrespondierend zu nur einem von den beiden Amplitudenspitzenwerten des Trägersignals auftretendes, eine Impulsbreite kleiner als die halbe Periodendauer des Trägersignals aufweisendes Schaltsignal für die Ansteuerung der Schalteinrichtung angeleitet wird. Die Umwandlung des eine Fehlposition in seiner Amplitude widerspiegelnden Regelsignals in ein Signal zur Ansteuerung des Primärkreises des Transformators erfolgt also hier mit einem Amplitudenmodulator, der in seinem Aufbau sehr einfach ist, wobei für denselben auch im Handel erhältliche Bausteine verwendet werden können. Dabei wird dem Primärkreis des Transformators ein periodisches Signal zugeführt, das mit gutem Wirkungsgrad auf den Sekundärkreis transformiert wird, wobei dann durch die zeitlich jeweils korrespondierend zu nur einem von den beiden Amplitudenspitzenwerten des Trägersignals erfolgende Ansteuerung der Schalteinrichtung gerade die Amplitudenspitzenwerte der am Sekundärkreis auftretenden Spannung auf das piezoelektrische Element übertragen werden. Diese Übertragung der Amplitudenspitzenwerte der am Sekundärkreis auftretenden Spannung erfolgt daher nach der Art einer Abtaststufe, wie sie auch unter der Bezeichnung „Sample and Hold" bekannt ist. Auf diese Weise wird insgesamt gesehen ein sehr guter Wirkungsgrad erreicht, so dass nur relativ wenig Energie zur Erzeugung der relativ hohen Steuerspannung erforderlich ist.

Als sehr vorteilhaft hat sich erwiesen, wenn die Signalwandlerstufe als Amplitudenmodulator mit unterdrücktem Träger ausgebildet ist. Ein solcher Amplitudenmodulator hat bekanntlich die Eigenschaft, dass sein moduliertes, im wesentlichen trägerfrequentes Ausgangssignal die Phase wechselt, wenn das Modulationssignal relativ zu einem Bezugspegel sein Vorzeichen ändert. Im Zusammenhang mit der erfindungsgemässen Schaltungsanordnung ergibt daher ein solcher Amplitudenmodulator die Möglichkeit, auf einfache Weise Regelsignale beider Polarität zu verarbeiten und damit das piezoelektrische Element von einer Ruhelage ausgehend in zwei zueinander entgegengesetzte Richtungen auszulenken, wodurch ein doppelt so grosser Bereich für eine Positionierung erhalten wird, als wenn das Positionierelement nur in einer Richtung auslenkbar ist; beziehungsweise ist es zum Erreichen eines gleich grossen Bereiches für eine Positionierung nicht erforderlich, das piezoelektrische Element mit einer konstanten Vorspannung zu betreiben, was wiederum einen Energieverlust bedeuten würde.

In diesem Zusammenhang hat sich weiters als vorteilhaft erwiesen, wenn der Amplitudenmodulator als Doppelgegentaktmodulator ausgebildet ist. Ein Doppelgegentaktmodulator stellt bekanntlich einen speziellen Fall eines Amplitudenmodulators mit unterdrücktem Träger dar, welcher sich dadurch auszeichnet, dass sein Ausgangssignal ein Minimum an Seitenbandfrequenzen aufweist und daher weitgehendst dem trägerfrequenten Signal folgt, was dann auch für das am Sekundärkreis des Transformators auftretende Signal gilt. Auf diese Weise wird bei einer erfindungsgemässen Schaltungsanordnung mit einem solchen Amplitudenmodulator erreicht, dass die vom Schaltsignal, das seinerseits vom Trägersignal abgeleitet ist, bei der Ansteuerung der Schalteinrichtung durch dasselbe festgelegten Abtastzeitpunkte zur Übertragung der am Sekundärkreis des Transformators auftretenden Spannung auf das piezoelektrische Element besonders gut mit den Amplitudenspitzenwerten dieser am Sekundärkreis auftretenden Spannung übereinstimmen, wodurch sich die Energieübertragung besonders günstig gestaltet.

Weiters hat sich als vorteilhaft erwiesen, wenn der Transformator für die Frequenz der Grundwelle des Trägersignals auf Parallelresonanz abgestimmt ist. Unter Ausnützung der Resonanzüberhöhung wird auf diese Weise eine weitere Optimierung der Energieübertragung erreicht.

Als sehr vorteilhaft hat sich auch erwiesen, wenn der Oszillator als ein ein Sinussignal liefernder Oszillator ausgebildet ist. Mit einem solchen Signal, das im wesentlichen nur aus einer Grundwelle besteht, erfolgt im Transformator eine sehr günstige Energieübertragung.

Zweckmässigerweise kann aber auch der Oszillator als ein ein Sägezahnsignal liefernder Oszillator ausgebildet sein. Auf diese Weise wird die Schaltungsanordnung an sich sehr einfach, da Oszillatoren dieser Art mit sehr geringem Schaltungsaufwand herstellbar sind. Da ein Sägezahnsignal aber mehr Oberwellen aufweist, gestaltet sich allerdings die Energieübertragung im Transformator nicht mehr so günstig als bei Verwendung eines Oszillators, der ein Sinussignal liefert.

In diesem Zusammenhang kann aber eine Verbesserung hinsichtlich der Energieübertragung wieder erreicht werden, wenn der Oszillator als ein ein symmetrisches Sägezahnsignal liefernder Oszillator ausgebildet ist. Dies ist darauf zurückzuführen, dass ein solches Sägezahnsignal wieder eine sehr ausgeprägte Grundwelle besitzt, die vom Transformator gut übertragen wird.

Die Wahl der Impulsbreite des Schaltsignals für die Ansteuerung der Schalteinrichtung unterliegt verschiedenen Gesichtspunkten. Einerseits soll angestrebt werden, dass möglichst genau die Amplitudenspitzenwerte des am Sekundärkreis des Transformators auftretenden Signale abgetastet werden, da diese das momentane Regelsignal repräsentieren, was bedeutet, dass die in Rede stehende Impulsbreite möglichst klein gewählt werden sollte. Andererseits steigt aber mit kleiner werdender Impulsbreite der erforderliche Ladestrom, um das piezoelektrische Element auf den jeweiligen Amplitudenspitzenwert der am Sekundärkreis des Transformators auftretenden Spannung umzuladen, und es machen sich auch Phasenverschiebungen zwischen dem Schaltsignal und dem Ausgangssignal des Amplitudenmodulators beziehungsweise der am Sekundärkreis des Transformators auftretenden Spannung stärker ungünstig bemerkbar, da es dann leichter dazu kommen kann, dass nicht mehr die tatsächlichen Amplitudenspitzenwerte der am Sekundärkreise des Transformators auftretenden Spannung abgetastet werden. Um den vorstehend angeführten, einander widersprechenden Anforderungen möglichst gut gerecht zu werden, hat sich als besonders günstig erwiesen, wenn die Impulsbreite des Schaltsignals für die Ansteuerung der Schalteinrichtung in der Grössenordnung von einem Zehntel der Periodendauer des Trägersignals gewählt ist.

Es gibt verschiedene Anwendungsfälle, wie beispielsweise bei der magnetischen Aufzeichnung und/oder Wiedergabe von Fernsehsignalen, bei welchen mehrere piezoelektrische Elemente, von denen jedes einer eigenen Positionierungseinrichtung angehört, entsprechend zu positionieren sind. In einem solchen Fall kann natürlich für jeden dieser piezoelektrischen Elemente eine eigene erfindungsgemässe Schaltungsanordnung vorgesehen sein. In diesem Zusammenhang wird ein besonderer Vorteil dadurch erhalten, dass zur Erzeugung je einer Steuerspannung für mindestens zwei piezoelektrische Elemente einer entsprechenden Anzahl von Positionierungseinrichtungen jedem der piezoelektrischen Elemente ein Amplitudenmodulator, ein Transformator und eine Schalteinrichtung zugeordnet sind und dass zur Erzeugung eines Trägersignals für alle Amplitudenmodulatoren ein einziger Oszillator und zur Erzeugung eines Schaltsignals für die Ansteuerung aller Schalteinrichtungen eine einzige Impulserzeugerstufe vorgesehen ist. Durch eine derartige Mehrfachausnützung einzelner Schaltungsteile wird eine wesentliche Vereinfachung der gesamten Schaltung erreicht, wobei auch sichergestellt wird, dass die Erzeugung der untereinander verschiedenen Steuerspannungen für die einzelnen piezoelektrischen Elemente unter möglichst gleichen Voraussetzungen erfolgt, da hierbei stets ein und dasselbe Trägersignal und Schaltsignal zur Verarbeitung gelangt.

In diesem Zusammenhang hat sich bei einer Schaltungsanordnung, bei der eine Schalteinrichtung durch die Parallelschaltung je eines Transistors mit einer in Serie zu seinem Kollektor liegenden Diode gebildet ist, die beiden Transistoren entgegengesetzten Leitfähigkeitstyps aufweisen und die beiden Dioden in Durchlassrichtung zum betreffenden Transistor gepolt und an ein Ende des Sekundärkreises des dem betreffenden piezoelektrischen Element zugeordneten Transformators angeschlossen sind, an dessen anderes Ende dieses piezoelektrische Element seinerseits angeschlossen ist, wie dies ebenfalls aus der eingangs angeführten AT-PS Nr. 364548 bekannt ist, weiters als vorteilhaft erwiesen, wenn die beiden Transistoren, deren Basen das Schaltsignal in Gegenphase zugeführt wird, allen Schalteinrichtungen gemeinsam, jeder Schalteinrichtung aber separat die beiden Dioden zugeordnet sind, wobei alle Dioden gleicher Polung je für sich in Serie zum Kollektor des betreffenden Transistors liegen. Auf diese Weise ist auch eine Mehrfachausnützung von einzelnen Teilen der Schalteinrichtungen möglich, was eine weitere Vereinfachung der gesamten Schaltung mit sich bringt.

Im Hinblick auf eine sehr einfache Ausbildung der Schaltungsanordnung hat sich auch als vorteilhaft erwiesen, wenn als Schalteinrichtung ein Triac vorgesehen ist, dessen Haltestrom grösser ist als der bei der Steuerung des piezoelektrischen Elements maximal durch den Triac fliessende Strom. Auf diese Weise werden die bipolaren Schaltfunktionen mit einem einzigen Bauelement erreicht, wobei durch die hier speziell gewählte Betriebsweise für den Triac gewährleistet wird, dass eine bipolare Schaltfunktion nur während der Ansteuerung durch das Schaltsignal aufrechterhalten bleibt und nicht so lange andauert, bis die an ihm anliegende Spannung bis auf den Wert Null absinkt.

Ebenfalls als vorteilhaft hinsichtlich eines einfachen Schaltungsaufbaues hat sich erwiesen, wenn als Schalteinrichtung eine Brückengleichrichterschaltung vorgesehen ist, die mit einer Brückendiagonale zwischen dem Sekundärkreis des Transformators und dem piezoelektrischen Element liegt und in deren andere Brückendiagonale ein vom Schaltsignal angesteuerter Transistor aufgenommen ist.

Die Erfindung wird im folgenden anhand der Zeichnungen, in welchen einige Ausführungsbeispiele der Erfindung dargestellt sind, auf die sie jedoch nicht beschränkt sein soll, näher erläutert.

Fig. 1 zeigt ein Blockschaltbild einer erfindungsgemässen Schaltungsanordnung zur Erzeugung einer Steuerspannung für ein piezoelektrisches Element einer Positionierungseinrichtung.

Fig. 2 zeigt unter a bis e Diagramme zur Erläuterung der Wirkungsweise einer Schaltungsanordnung nach Fig. 1.

Fig. 3 zeigt die Schaltung eines Doppelgegentaktmodulators, der in einer Schaltungsanordnung nach Fig. 1 zur Anwendung gelangen kann.

Fig. 4 zeigt unter a bis e Diagramme zur Erläuterung der Wirkungsweise einer Schaltungsanordnung nach Fig. 1 mit einem Doppelgegentaktmodulator nach Fig. 3.

Fig. 5 zeigt ein Schaltungsdetail, bei dem der Transformator als Gegentakttransformator ausgeführt ist.

Fig. 6 zeigt ein Schaltungsdetail, bei dem der Transformator von einer niederohmigen Quelle her gespeist wird.

Fig. 7 zeigt eine Ausführungsform einer bipolaren Schalteinrichtung, die mit zwei Transistoren und zwei Dioden aufgebaut ist.

Fig. 8 zeigt eine Ausführungsform für eine bipolare Schalteinrichtung, bei der ein Triac zur Anwendung kommt.

Fig. 9 zeigt eine Ausführungsform einer bipolaren Schalteinrichtung, die als Brückengleichrichterschaltung aufgebaut ist.

Fig. 10 zeigt eine Ausführungsform für eine Impulserzeugerstufe, die als Schwellwerteinrichtung arbeitet.

Fig. 11 zeigt unter a bis c Diagramme zur Erläuterung der Wirkungsweise einer Impulserzeugerstufe nach Fig. 10.

Fig. 12 zeigt eine Schaltungsanordnung zur Erzeugung je einer Steuerspannung für zwei piezoelektrische Elemente, die je einer Positionierungseinrichtung angehören.

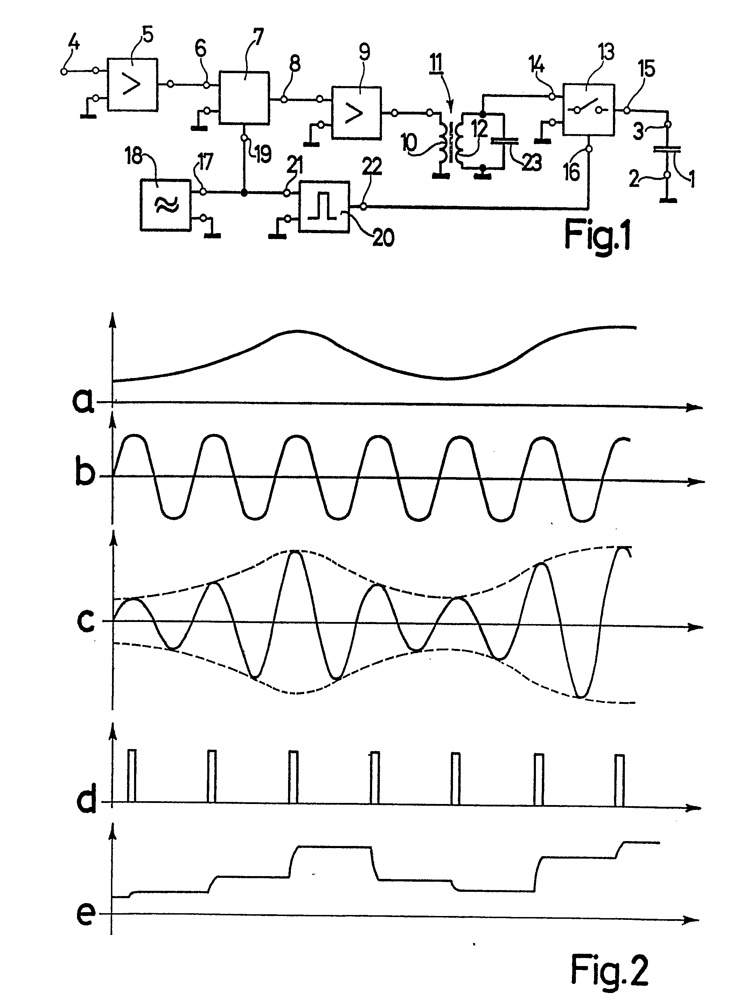

Im Blockschaltbild nach Fig. 1 ist ein piezoelektrisches Element, im folgenden kurz Piezoelement genannt, einer Positionierungseinrichtung durch eine Kapazität 1 repräsentiert. Ein solches Piezoelement kann beispielsweise aus zwei streifenförmigen Schichten aus piezoelektrischem Material bestehen, die beim Anlegen eines elektrischen Feldes in entgegengesetzter Richtung ihre Länge ändern, wodurch sich eine Auslenkung des Piezoelements ergibt. Diese beiden Schichten sind dabei auf einer gemeinsamen leitenden Schicht angebracht und auf den dieser Schicht gegenüberliegenden Seiten mit Elektroden versehen, die elektrische Anschlusspunkte aufweisen, welche in Fig. 1 mit 2 und 3 bezeichnet sind. In elektrischer Hinsicht verhält sich ein solches Piezoelement zwischen diesen Anschlusspunkten 2 und 3 wie eine Kapazität. Wird ein solches Piezolement an einem Ende eingespannt und an seine Anschlusspunkte 2 und 3 eine Steuerspannung angelegt, so biegt es sich proportional zu dieser Steuerspannung durch, was zur Folge hat, dass das freie Ende des Piezoelements eine translatorische Bewegung ausführt und dementsprechend seine Position ändert. Damit kann ein an diesem freien Ende des Piezoelements angebrachter Gegenstand in eine bestimmte Position gebracht werden. Beispielsweise kann ein solcher Gegenstand ein magnetkopf sein, der dann mit der Positionierungseinrichtung in bezug auf eine Informationsspur eingestellt werden kann, so dass er dieser exakt folgt.

Die für derartige Piezoelemente erforderlichen Steuerspannungen sind relativ hoch und liegen in der Grössenordnung von 150 V. Demgemäss erfordert auch die Erzeugung solcher Steuerspannungen relativ viel Energie, was sich insbesondere bei von Batterien betriebenen Einrichtungen ungünstig auswirken kann. Um hier Abhilfe zu schaffen, ist die in Fig. 1 angegebene Schaltungsanordnung vorgesehen, die sich auch durch einen sehr einfachen Schaltungsaufbau auszeichnet.

Die Einstellung des mit der Positionierungseinrichtung in die gewünschte Lage zu bringenden Gegenstandes erfolgt in Abhängigkeit eines Regelsignals, das die jeweilige Fehlposition des Gegenstandes von seiner Sollposition als dementsprechende Amplitude widerspiegelt. Die Schaltungsanordnung nach Fig. 1 wandelt ein solches Regelsignal in eine entsprechende Steuerspannung für das Piezoelement um. Hierzu wird das Regelsignal der Eingangsklemme 4 der Schaltungsanordnung zugeführt, von der es, ggf. nach Verstärkung in einem Verstärker 5, an den Eingang 6 einer Signalwandlerstufe 7 gelangt. Das am Ausgang 8 der Signalwandlerstufe 7 auftretende Ausgangssignal derselben wird, ggf. wieder nach Verstärkung in einem Verstärker 9, an den Primärkreis 10 eines Transformators 11 angelegt. Mit diesem Transformator 11 wird das Ausgangssignal der Signalwandlerstufe 7 auf eine entsprechend hohe Spannung transformiert, die dann an seinem Sekundärkreis 12 auftritt. Diese Spannung am Sekundärkreis 12 des Transformators 11 wird innerhalb vorgegebener Zeitabschnitte mit einer bipolaren Schalteinrichtung 13, deren zwischen ihren Anschlussklemmen 14 und 15 verlaufende, einen Stromfluss in beiden Richtungen ermöglichende Schaltstrecke zwischen den Sekundärkreis 12 und den Anschlusspunkt 3 des Piezoelements eingeschaltet ist, auf die Kapazität 1 des Piezoelements als Steuerspannung für dasselbe übertragen. Die Zeitabschnitte für eine solche Spannungsübertragung werden dabei durch ein Schaltsignal für die Ansteuerung der Schalteinrichtung 13 festgelegt, das einem Steuereingang 16 derselben zugeführt wird und das bei seinem Auftreten bewirkt, dass die Schaltstrecke der Schalteinrichtung für eine der beiden Stromflussrichtung niederohmig wird. Somit kann mit dieser Schaltungseinrichtung 13 entweder elektrische Ladung vom Sekundärkreis 12 des Transformators 11 auf die Kapazität 1 des Piezoelements übertragen oder von dieser wieder abgeführt werden, je nachdem ob die am Sekundärkreis 12 auftretende Spannung grösser oder kleiner ist als die Spannung an der Kapazität des Piezoelements.

Bei einer solchen Schaltungsanordnung ist nun vorgesehen, dass die Signalwandlerstufe 7 als Amplitudenmodulator ausgebildet ist, wobei das ihrer Eingangsklemme 6 zugeführte Regelsignal das Modulationssignal bildet, welches einem periodischen Trägersignal in bekannter Weise aufmoduliert wird. Das hierfür erforderliche Trägersignal, das wie üblich höherfrequenter als das Modulationssignal gewählt ist, wird von einem Ausgang 17 eines Oszillators 18 einem weiteren Eingang 19 der Signalwandlerstufe 7 zugeführt. Am Ausgang 8 der Signalwandlerstufe 7 tritt dann als deren Ausgangssignal ein amplitudenmoduliertes Signal auf, in dem die jeweiligen Amplitudenspitzenwerte des Trägersignals das ursprüngliche Regelsignal widerspiegeln. Dieses Ausgangssignal gelangt über den Verstärker 9 an den Primärkreis 10 des Transformators 11 und wird von diesem auf seinen Sekundärkreis 12 transformiert. Da hierbei in diesem zu transformierenden Signal das periodische Trägersignal vorherrscht, erfolgt die Transformierung im Transformator 11 mit sehr gutem Wirkungsgrad.

Weiter ist vorgesehen, dass vom Trägersignal über eine Impulserzeugerstufe 20 ein periodisches, impulsförmiges, zeitlich jeweils korrespondierend zur nur einem von den beiden Amplitudenspitzenwerten des Trägersignals auftretendes, eine Impulsbreite kleiner als die halbe Periodendauer des Trägersignals aufweisendes Schaltsignal für die Ansteuerung der Schalteinrichtung 13 abgeleitet wird. Demgemäss ist an den Ausgang 17 des Oszillators 18 auch der Eingang 21 der Impulserzeugerstufe 20 angeschlossen, deren Ausgang 22 dann mit dem Steuereingang 16 der Schalteinrichtung 13 in Verbindung steht. Da das von der Impulserzeugerstufe 20 gelieferte impulsförmige Schaltsignal vom Trägersignal abgeleitet ist, wobei es jeweils korrespondierend zu einem bestimmten Amplitudenspitzenwert desselben auftritt, ist erreicht, dass die Schalteinrichtung 13 gerade immer dann aktiviert wird, wenn auch die Spannung am Sekundärkreis 12 des Transformators 11, entsprechend dem mit dem Regelsignal amplitudenmodulierten Trägersignal, einen Amplitudenspitzenwert erreicht. Auf diese Weise werden daher immer die das Regelsignal repräsentierenden Amplitudenspitzenwerte der am Sekundärkreis 12 des Transformators auftretenden Spannung für die Beeinflussung der Spannung an der Kapazität des Piezoelements herangezogen, was zur Folge hat, dass die Auslenkung des Piezoelements entsprechend dem jeweiligen Regelsignal erfolgt.

Zweckmässigerweise ist der Transformator 11 für die Frequenz der Grundwelle des Trägersignals auf Parallelresonanz abgestimmt, was durch Parallelschalten eines entsprechend gewählten Kondensators 23 zum Sekundärkreis 12 geschehen kann. Auf diese Weise kann bei der Transformation des amplitudenmodulierten Signals, dem das trägerfrequente Signal zugrunde liegt, für das Trägersignal die Resonanzüberhöhung ausgenützt werden, wodurch sich ein besonders guter Wirkungsgrad ergibt. Da dabei die Grundwelle des Trägersignals bevorzugt übertragen wird, treten die Amplitudenspitzenwerte des am Sekundärkreis des Transformators auftretenden Signals in guter Übereinstimmung gleichzeitig mit den Amplitudenspitzenwerten des Trägersignals auf, von dem aber seinerseits das Schaltsignal abgeleitet ist, was bedeutet, dass das Aktivieren der Schalteinrichtung in guter Übereinstimmung mit den Amplitudenspitzenwerten des am Sekundärkreis des Transformators auftretenden Signals erfolgt. Damit werden aber auch die das Regelsignal repräsentierenden Amplitudenspitzenwerte des am Sekundärkreis des Transformators auftretenden Signals einwandfrei auf die Kapazität des Piezoelements zu dessen dementsprechender Auslenkung übertragen. Es sei aber erwähnt, dass ein solcher Kondensator 23 zur Resonanzabstimmung des Transformators nicht zwingend notwendig ist, sondern dass durch sein Vorsehen die Funktionsweise der Schaltungsanordnung nur noch weiter verbessert wird.

Hinsichtlich der Ausbildung des Amplitudenmodulators an sich ist festzustellen, dass hierfür alle zum Stand der Technik zu zählenden Schaltungen herangezogen werden können. So kann beispielsweise ein solcher Amplitudenmodulator 7 einfach durch ein nichtlineares Schaltungselement gebildet sein, dem in Serie das Modulationssignal und das Trägersignal zugeführt werden und dem auch in Serie das modulierte Signal entnommen wird. Mit einem solchen Amplitudenmodulator kann ein Regelsignal als Modulationssignal verarbeitet werden, das relativ zu einem Bezugspegel sein Vorzeichen nicht ändert. Die diesbezüglichen Signalverläufe sind in den Diagrammen von Fig. 2 dargestellt. Das Diagramm a zeigt den angenommenen Verlauf eines Regelsignals, wobei die Abszisse den Bezugspegel bildet. Das Diagramm b zeigt das gegenüber dem Regelsignal höherfrequente Trägersignal. Im Hinblick auf das bereits zitierte Anwendungsbeispiel kann angenommen werden, dass das Regelsignal Frequenzkomponenten bis etwa 1 kHz enthalten kann; in einem solchen Fall empfiehlt sich, die Frequenz des Trägersignals in der Grössenordnung von 40 kHz zu wählen. Das Diagramm c zeigt das sich in einem solchen Fall ergebende amplitudenmodulierte Signal, welches dann das Ausgangssignal der Signalwandlerstufe 7 bildet. Wie ersichtlich, ist in einem solchen Signal das periodische Trägersignal vorwiegend vorhanden, so dass dasselbe im weiteren durch den Transformator 11 mit gutem Wirkungsgrad transformiert wird. Das Diagramm d zeigt das periodische, impulsförmige Schaltsignal für die Ansteuerung der Schalteinrichtung 13, das durch eine Impulserzeugerstufe 20 vom Trägersignal abgeleitet wird, derart, dass die Impulse zeitlich jeweils korrespondierend zu nur einem von den beiden Amplitudenspitzenwerten des Trägersignals, nämlich hier den positiven Amplitudenspitzenwerten, auftreten, wobei ihre Impulsbreite so gewählt ist, dass sie etwa ein Zehntel der Periodendauer des Trägersignals ist, was sich in der Praxis als sehr günstig erwiesen hat. Wie aus den Diagrammen c und d ersichtlich ist, korrespondieren die Impulse des Schaltsignals mit den Amplitudenspitzenwerten des modulierten Signals, das auch am Sekundärkreis 12 des Transformators 11 auftritt, was darauf zurückzuführen ist, dass dieses modulierte Signal im wesentlichen von den Signalanteilen des Trägersignals gebildet ist, von dem aber seinerseits wiederum die Impulse des Schaltsignals abgeleitet sind. Auf diese Weise wird daher die Schalteinrichtung 13 vom Schaltsignal immer dann aktiviert, wenn das modulierte Signal seine betreffenden Amplitudenspitzenwerte erreicht. Demgemäss werden die Amplitudenspitzenwerte der am Sekundärkreis 12 des Transformators auftretenden Spannung mit der Schalteinrichtung 13 auf die Kapazität des Piezoelements übertragen, wie dies im Diagramm e angegeben ist, wobei sich zufolge der bipolaren Wirkungsweise der Schalteinrichtung die Spannung am Piezoelement entweder vergrössert oder verkleinert, je nachdem ob die an ihm anliegende momentane Spannung kleiner oder grösser ist als der Amplitudenspitzenwert der Spannung am Sekundärkreis 12. Dementsprechend fliesst über die Schalteinrichtung 13 entweder ein Ladestrom vom Sekundärkreis 12 des Transformators 11 zur Kapazität 1 des Piezoelements oder in der entgegengesetzten Richtung ein Entladestrom. Auf diese Weise ist erreicht, dass die am Piezolement anliegende Steuerspannung dem Regelsignal folgt, wobei ihre Gewinnung mit gutem Wirkungsgrad und mit einem einfachen Schaltungsaufbau erfolgt.

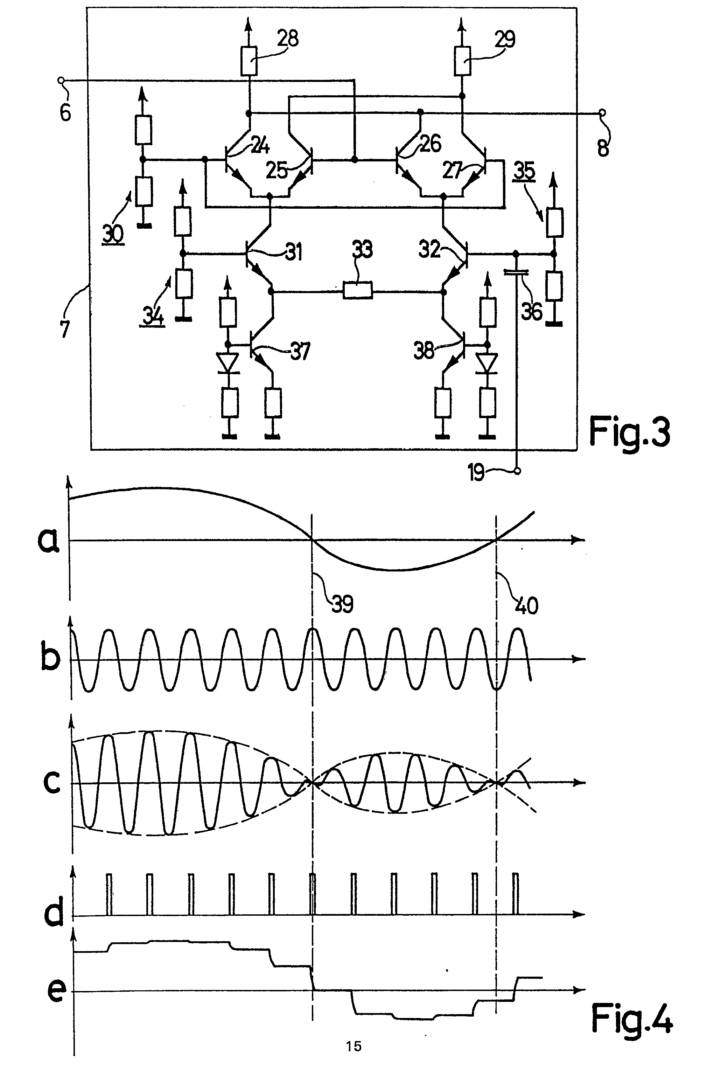

Eine andere, sehr vorteilhafte Ausführungsform für einen Amplitudenmodulator, der bei einer Schaltungsanordnung nach Fig. 1 zur Anwendung kommen kann, ist ein Doppelgegentaktmodulator, dessen Schaltung Fig. 3 zeigt, und der auch als Baustein im Handel unter der Typenbezeichnung TCA 240 erhältlich ist. Dieser Doppelgegentaktmodulator weist zwei Differenzverstärker auf, die durch je zwei emitterseitig miteinander verbundene Transistoren 24, 25 und 26, 27 gebildet sind, deren Kollektoren wechselweise mit zwei Arbeitswiderständen 28 und 29 in Verbindung stehen und von denen das Ausgangssignal des Modulators abgenommen werden kann, was hier vom Arbeitswiderstand 28 her geschieht. Den Basen der Transistoren 24 und 27 wird von einem Spannungsteiler 30 her ein Bezugspegel zugeführt, wogegen an die Basen der Transistoren 25 und 26 vom Eingang 6 her das Modulationssignal, also im vorliegenden Fall das Regelsignal, gleichspannungsmässig angelegt wird, da das Regelsignal auch eine Gleichspannungskomponente enthalten kann. In Serie zu den Emittern der Transistoren 24, 25 bzw. 27 dieser beiden Differenzverstärker liegt je ein Transistor 31 bzw. 32, von denen die Emitter über einen Widerstand 33 miteinander gekoppelt sind, so dass diese beiden Transistoren 31 und 32 ihrerseits als weiterer Differenzverstärker wirksam sind. Die Basen der Transistoren 31 und 32 liegen zur Arbeitspunkteinstellung an weiteren Spannungsteilern 34 bzw. 35, wobei der Basis des Transistors 32 über einen Kondensator 36 zusätzlich vom weiteren Eingang 19 her das Trägersignal zugeführt wird. In Serie zu den Emittern der beiden Transistoren 31 und 32 liegt weiters je ein als Stromquelle wirksamer Transistor 37 bzw. 38.

Bei einer derartigen Schaltungsanordnung tritt an den Kollektoren der Transistoren 31 und 32 das Trägersignal in Gegenphase auf, welches dann in den Transistoren 24, 25 und 26, 27 der beiden Differenzverstärker wechselweise mit dem Modulationssignal gegenphasig moduliert wird. Auf diese Weise entsteht am Ausgang 8 des Doppelgegentaktmodulators ein amplitudenmoduliertes Signal, das im wesentlichen nur aus zwei Komponenten besteht, nämlich dem Summensignal und dem Differenzsignal von Trägersignal und Modulationssignal, wobei das Trägersignal selbst unterdrückt ist. Ein solches moduliertes Signal weist bekanntlich die Eigenschaft auf, dass es die Phase wechselt, wenn das Modulationssignal relativ zu einem Bezugspegel sein Vorzeichen ändert. Im vorliegenden Zusammenhang kann dies vorteilhafterweise dazu ausgenützt werden, dass mit dem Doppelgegentaktmodulator auch ein Regelsignal verarbeitet werden kann, das seine Polarität hinsichtlich eines Bezugspegels ändert, je nachdem ob gegenüber einer Ruhelage des Piezoelements ein Positionsfehler in der einen oder der anderen Richtung vorliegt, wodurch dann auch eine Positionierung des Piezoelements in diesen beiden Richtungen möglich wird.

In den Diagrammen von Fig. 4 sind die diesbezüglichen Signalverläufe angegeben. Das Diagramm a zeigt den Verlauf des Regelsignals, wobei den Bezugspegel die Abszisse bildet. Dargestellt ist hierbei ein Regelsignal, das vorerst eine positive Amplitude, daran anschliessend eine negative Amplitude und an diese anschliessend wiederum eine positive Amplitude aufweist. Das Diagramm b zeigt das Trägersignal und das Diagramm c das amplitudenmodulierte Signal mit unterdrücktem Trägersignal. Durch die Ordinaten 39 und 40 sind die Zeitpunkt angegeben, zu denen das Regelsignal sein Vorzeichen ändert, wobei aus dem Diagramm c dabei zu entnehmen ist, dass an diesen Stellen das modulierte Signal die Phase wechselt. Das Diagramm d zeigt das periodische, impulsförmige Schaltsignal, mit dem die Schalteinrichtung 13 angesteuert wird und das durch die Impulserzeugerstufe 20 wieder in der Weise vom Trägersignal abgeleitet ist, dass seine Impulse immer zeitlich jeweils korrespondierend zu nur einem von den beiden Amplitudenspitzenwerten des Trägersignals, nämlich hier den positiven Amplitudenspitzenwerten, auftreten. Auf diese Weise ist wieder erreicht, dass die Impulse des Schaltsignals zu Zeitpunkten auftreten, die den Amplitudenspitzenwerten des modulierten Signals entsprechen, da dieses dem Trägersignal weitgehend folgt. Da aber nunmehr bei einem Wechsel des Vorzeichens des Regelsignals das modulierte Signal seine Phase ändert, bedeutet dies, dass bei einer solchen Phasenänderung die Impulse des Schaltsignals dann zu Zeitpunkten auftreten, die mit den vorzeichenmässig entgegengesetzten Amplitudenspitzenwerten des modulierten Signals zusammenfallen, wie ein Vergleich der Diagramme c und d erkennen lässt. In der Schaltungsanordnung nach Fig. 1 hat dies dann zur Folge, dass auch die Spannung an der Kapazität des Piezoelements das Vorzeichen ändern kann, je nach dem Verlauf des Regelsignals, wie dies das Diagramm e zeigt. Damit können aber in bezug auf eine Ruhelage des Piezoelements Positionsfehler in beiden Richtungen ausgeglichen werden.

Im folgenden werden einige Beispiele für weitere mögliche Ausgestaltungen der Schaltungsanordnung nach Fig. 1 erläutert.

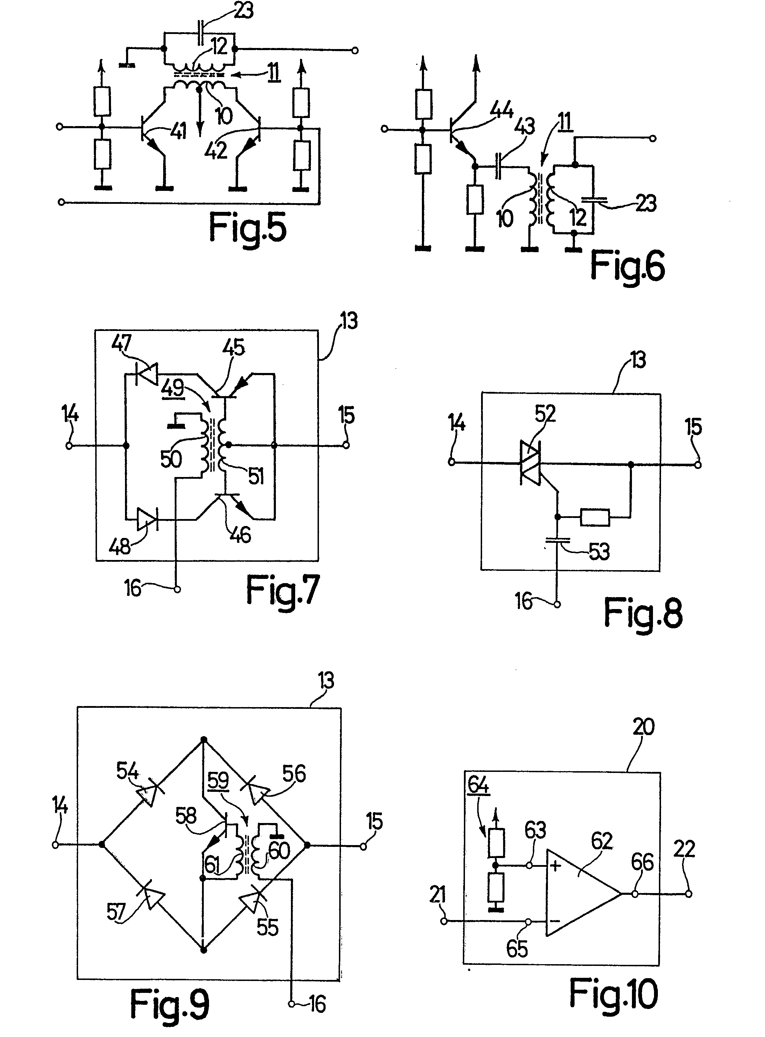

Fig. 5 zeigt eine Ausbildung des Transformators 11 als Gegentakttransformator hinsichtlich seines Primärkreises 10, der hier kollektorseitlich von zwei Transistoren 41 und 42 gegenphasig gespeist wird. Demgemäss ist auch den Basen der beiden Transistoren 41, 42 das Ausgangssignal des Amplitudenmodulators gegenphasig zuzuführen, was bei einem Doppelgegentaktmodulator nach Fig. 3 einfach dadurch möglich ist, dass das zweite gegenphasige Signal zusätzlich vom Arbeitswiderstand 29 abgenommen wird.

Der Primärkreis des Transformators 11 kann sowohl von einer hochohmigen Quelle her als auch von einer niederohmigen Quelle her gespeist werden. Der erstgenannte Fall liegt dann vor, wenn der Primärkreis des Transformators beispielsweise vom Kollektor eines Transistors her gespeist wird. Eine Speisung von einer niederohmigen Quelle her zeigt die Schaltung nach Fig. 6, gemäss welcher der Primärkreis 10 des Transformators 11 über einen Kondensator 48 an den Emitter eines Transistors 44 angeschlossen ist, dessen Basis das amplitudenmodulierte Signal zugeführt wird. Ist der Transformator 11 mit einem Kondensator 23 für die Frequenz der Grundwelle des Trägersignals auf Parallelresonanz abgestimmt, so weisen die beiden vorstehend angeführten Anspeisungsarten für den Transformator, je nach den schaltungstechnischen Gegebenheiten, unterschiedliche Vorteile auf. Bei einer Speisung von einer hochohmigen Quelle her ist der Energiebedarf geringer, es machen sich aber Abweichungen von der Resonanzabstimmung, die durch Toleranzen der Schaltungselemente bedingt sein können, relativ stark bemerkbar, da es dabei zu Phasenunterschieden zwischen dem Schaltsignal und dem am Sekundärkreis des Transformators auftretenden Signal kommen kann, was dann zur Folge hat, dass nicht mehr die tatsächlichen Amplitudenspitzenwerte des letztgenannten Signals abgetastet werden und damit das Steuersignal für das Piezoelement nicht mehr vollständig dem Regelsignal proportional ist. Eine solche Anspeisungsart wird man daher wählen, wenn auf einfache Weise ein Resonanzabgleich möglich ist. Demgegenüber benötigt eine Speisung von einer niederohmigen Quelle her etwas mehr Energie, es machen sich aber in diesem Fall Abweichungen von der Resonanzabstimmung weniger bemerkbar, da die dabei auftretenden Phasenunterschiede zwischen den beiden vorgenannten Signalen geringer sind. Eine solche Anspeisungsart wird daher zweckmässigerweise dann gewählt, wenn ein eigener Resonanzabgleich nicht ohne weiteres möglich ist.

Fig. 7 zeigt eine Schaltungsanordnung für eine Ausbildung der Schalteinrichtung 13. Diese ist hier durch die Parallelschaltung je eines Transistors 45 bzw. 46 mit einer in Serie zu seinem Kollektor liegenden Diode 47 bzw. 48 gebildet, wobei die beiden Transistoren 45, 46 entgegengesetzten Leitfähigkeitstyp aufweisen und die beiden Dioden 47, 48 in Durchlassrichtung zum betreffenden Transistor 45 bzw. 46 gepolt sind. Diese Parallelschaltung, die einerseits mit der Anschlussklemme 14 und andererseits mit der Anschlussklemme 15 der bipolaren Schalteinrichtung 13 verbunden ist, bildet deren Schaltstrecke. Den Basen der beiden Transistoren 45 und 46 wird das Schaltsignal vom Steuereingang 16 her in Gegenphase zugeführt, wozu im vorliegenden Fall ein Transformator 49 vorgesehen ist, dessen Primärkreis 50 mit dem Steuereingang 16 in Verbindung steht und dessen Sekundärkreis 51 als Gegentaktwicklung ausgeführt ist, deren Mittelanzapfung mit den Emittern der beiden Transistoren 45 und 46 in Verbindung steht und deren Wicklungsenden an die Basen der Transistoren 45 bzw. 46 angeschlossen sind. Auf diese Weise ist das Schaltsignal in der Lage beider Transistoren 45 bzw. 46 zu öffnen, wobei dann jeweils derjenige von ihnen leitend wird, der entsprechend der Polarität der zwischen den Anschlussklemmen 14 und 15 vorhandenen Spannung sich in Durchlassrichtung befindet, wogegen der andere Transistor gesperrt bleibt. Die Dioden 47 bzw. 48 dienen dabei zum Spannungsschutz des betreffenden Transistors 45 bzw. 46, wenn sich dieser im gesperrten Zustand befindet. Auf diese Weise ist über die Schalteinrichtung 13 ein Stromfluss in beiden Richtungen möglich, wobei immer einer der beiden Transistoren 45 bzw. 46 gesperrt ist.

Fig. 8 zeigt eine sehr einfache Schaltungsanordnung für eine Schalteinrichtung 13, die hier durch einen Triac 52 gebildet ist, dessen Durchlassstrecke zwischen die Anschlussklemmen 14 und 15 der Schalteinrichtung gelegt ist und dessen Steuerelektrode das Schaltsignal über einen Kondensator 53 vom Steuereingang 16 her zugeführt wird. Die Betriebsweise des Triac erfolgt dabei derart, dass sein Haltestrom grösser ist als der, hier bei der Steuerung des Piezoelements, maximal durch ihn fliessende Strom, wodurch sichergestellt ist, dass seine bipolare Schaltfunktion nur während der Ansteuerung durch das Schaltsignal aufrechterhalten bleibt und nicht so lange andauert, bis die an ihm anliegende Spannung bis auf den Wert Null absinkt.

Bei der Schaltungsanordnung nach Fig. 9 ist die Schalteinrichtung 13 durch eine Brückengleichrichterschaltung 54, 55, 56 und 57 gebildet, die mit einer Brückendiagonale zwischen den Anschlussklemmen 14 und 15 der Schalteinrichtung 13 liegt und in deren andere Brückendiagonale ein vom Schaltsignal angesteuerter Transistor 58 aufgenommen ist. Die Zuführung des Schaltsignals an die Basis des Transistors 58 erfolgt dabei über einen Transformator 59, dessen Primärkreis 60 mit dem Steuereingang 16 und dessen Sekundärkreis 61 mit der Basis-Emitterstrecke des Transistors 58 in Verbindung steht. Sobald der Transistor 58 vom Schaltsignal her leitend gesteuert wird, ist entweder über die Brückenzweige 54 und 55 oder 56 und 57 ein Stromfluss in einer der beiden Richtungen zwischen den Anschlussklemmen 14 und 15 möglich.

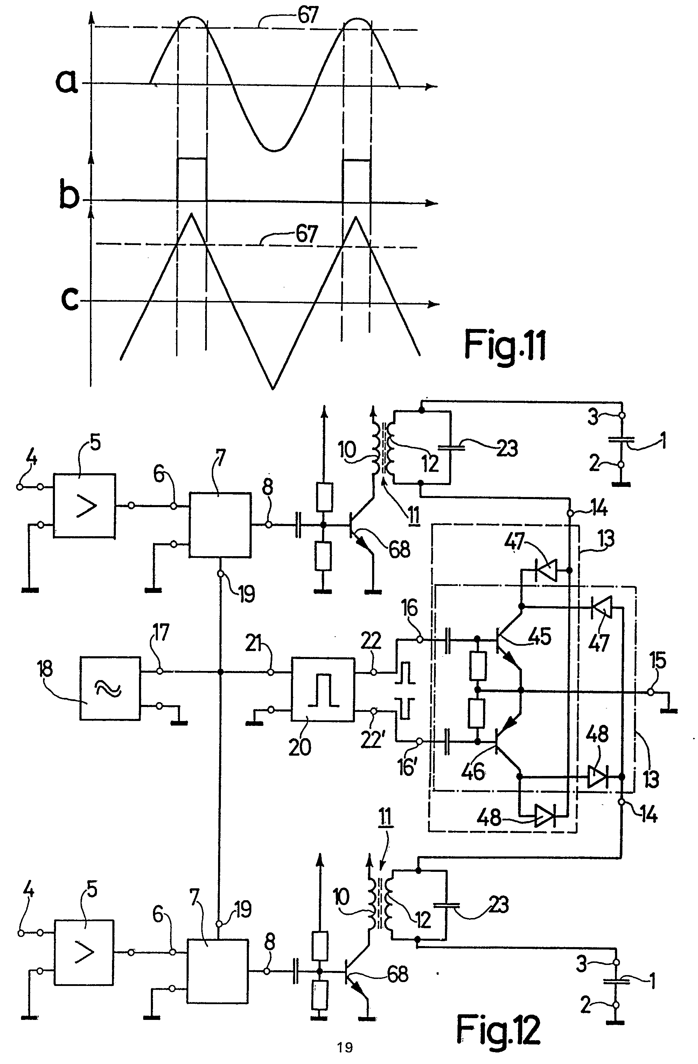

Fig. 10 zeigt eine Schaltungsanordnung für eine Impulserzeugerstufe 20, die als Schwellwerteinrichtung ausgebildet ist. Sie weist einen Operationsverstärker 62 auf, dem an einen Eingang 63 von einem Spannungsteiler 64 her eine Schwellwertspannung zugeführt wird. Der andere Eingang 65 des Operationsverstärkers steht mit der Eingangsklemme 21 der Impulserzeugerstufe 20 in Verbindung, der das Trägersignal zugeführt wird. Der Ausgang 66 des Operationsverstärkers ist mit der Ausgangsklemme 22 der Impulserzeugerstufe verbunden. In bekannter Weise werden hierdurch Impulse gebildet, die während derjenigen Zeitdauer auftreten, während der das dem Eingang 65 des Operationsverstärkers zugeführte Signal den durch den Spannungsteiler 64 festgelegten und dem anderen Eingang 63 des Operationsverstärkers zugeführten Schwellwert überschreitet. Die diesbezüglichen Signalverläufe sind in den Diagrammen der Fig. 11 dargestellt. Das Diagramm a zeigt das Trägersignal, wobei durch die strichlierte Linie 67 das Niveau des Schwellwertes angegeben ist. Hierbei ist angenommen, dass das Trägersignal aus einem Sinussignal besteht, das sich im vorliegenden Zusammenhang besonders gut als Trägersignal eignet, weil es sich im Zuge der weiteren Verarbeitung in der Schaltungsanordnung nach Fig. 1, als nur aus einer Grundwelle bestehendes Signal, besonders gut zur Transformation im Transformator 11 eignet. Das Diagramm b zeigt die mit der Impulserzeugerstufe 20 gewonnenen Impulse, die zeitlich jeweils korrespondierend zu nur einem von den beiden Amplitudenspitzenwerten des Trägersignals auftreten und eine Impulsbreite je nach dem gewählten Niveau des Schwellwertes aufweisen, wodurch diese Impulsbreite auf sehr einfache Weise gewählt werden kann. Im vorliegenden Zusammenhang erfolgt die Wahl dieser Impulsbreite nach den Gesichtspunkten, dass sie einerseits relativ klein sein soll, damit die Impulse möglichst nur zu den tatsächlichen Amplitudenspitzenwerten des Trägersignals auftreten, sie aber doch so gross ist, dass bei Abweichungen des Amplitudenspitzenwertes vom vorgegebenen Verlauf des Trägersignals diese Amplitudenspitzenwerte doch noch erfasst werden. Im Diagramm c ist ein Trägersignal gezeigt, das aus einem symmetrischen Sägezahnsignal besteht, wobei ersichtlich ist, dass auch von einem solchen Trägersignal mit der vorstehend beschriebenen Impulserzeugerstufe wieder das gewünschte Schaltsignal abgeleitet werden kann. Auch ein solches Trägersignal, das durch einen sehr einfach aufgebauten Oszillator erzeugt werden kann, eignet sich gut für eine Verarbeitung in einer Schaltungsanordnung nach Fig. 1, da es eine ausgeprägte Grundwelle aufweist, die wieder im Transformator 11 mit gutem Wirkungsgrad transformiert wird, insbesondere dann, wenn der Transformator auf diese Grundwelle in Parallelresonanz abgestimmt ist. An sich könnten aber auch unsymmetrische Sägezahnsignale als Trägersignal verwendet werden. Im Rahmen des bekannten Standes der Technik bestehen natürlich auch andere Möglichkeiten für die Ausbildung einer Impulserzeugerstufe, die Impulse erzeugt, die in vorgegebener Relation zu einem anderen Signal stehen, wie dies hier der Fall ist.

Beim Ausführungsbeispiel nach Fig. 12 werden für zwei Piezoelemente, die je einer Positionierungsrichtung angehören, je eine Steuerspannung erzeugt, wobei vorteilhafterweise verschiedene hierfür erforderliche Schaltungsteile doppelt ausgenützt werden können, so dass sich insgesamt eine einfachere Schaltungsanordnung ergibt. Jedem der beiden hier wieder durch je eine Kapazität 1 repräsentierten Piezoelemente ist dabei ein die Signalwandlerstufe bildender Amplitudenmodulator 7, ein Transformator 11 und eine Schalteinrichtung 13 zugeordnet, wogegen zur Erzeugung eines Trägersignals für beide Amplitudenmodulatoren ein einziger Oszillator 18 und zur Erzeugung eines Schaltsignals für die Ansteuerung beider Schalteinrichtungen 13 eine einzige Impulserzeugerstufe 20 vorgesehen ist. Die beiden für jedes Piezoelement separaten Regelsignale werden wieder Eingangsklemmen 4 zugeführt, von welchen die Regelsignale über Verstärker 5 als Modulationssignale den entsprechenden Amplitudenmodulatoren 17 zugeführt werden. Vom Ausgang 17 des einzigen Oszillators 18 gelangt das Trägersignal an die Eingänge 19 beider Amplitudenmodulatoren 7. Die an den Ausgangsklemmen 8 der Amplitudenmodulatoren 7 auftretenden Ausgangssignale derselben werden in je einem Transistor 68 verstärkt, der von seinem Kollektor her den Primärkreis 10 des dem betreffenden Piezoelement zugeordneten Transformators 11 speist. Die Piezoelemente sind hier mit ihren Anschlusspunkten 3 direkt an ein Ende des Sekundärkreises 12 des betreffenden Transformators 11 und mit ihren Anschlusspunkten 2 an das Bezugspotential gelegt. Dementsprechend sind die Schalteinrichtungen 13 mit ihren Anschlussklemmen 14 an das andere Ende des Sekundärkreises 12 des betreffenden Transformators 11 und mit ihren Anschlussklemmen 15 ihrerseits an das Bezugspotential gelegt, wodurch sie elektrisch gesehen wieder zwischen den Sekundärkreisen 12 des Transformators 11 und den Piezoelementen liegen. Dadurch, dass die Schalteinrichtungen 13 hier einseitig mit dem Bezugspotential in Verbindung stehen, gestaltet sich das Zuführen der Schaltsignale schaltungstechnisch einfacher, da hierbei ohne einen Transformator das Auslangen gefunden wird. Diese Schaltsignale zur Ansteuerung der beiden Schalteinrichtungen 13 werden in einer einzigen Impulserzeugerstufe 20 gewonnen, deren Eingang 21 ebenfalls an den Ausgang 17 des Oszillators 18 angeschlossen ist. Die Impulserzeugerstufe 20 weist hier jedoch zwei Ausgänge 22 und 22' auf, an denen das impulsförmige Schaltsignal in Gegenphase zur Verfügung steht. Die Schalteinrichtungen 13 sind analog zum Ausführungsbeispiel nach Fig. 7 aufgebaut, wobei eine Schalteinrichtung durch die Parallelschaltung je eines Transistors 45 bzw. 46 mit einer in Serie zu seinem Kollektor liegenden Diode 47 bzw. 48 gebildet ist, die beiden Transistoren 45, 46 entgegengesetzten Leitfähigkeitstyp aufweisen, und die beiden Dioden 47, 48 in Durchlassrichtung zum betreffenden Transistor 45 bzw. 46 gepolt und an ein Ende des Sekundärkreises 12 des dem betreffenden Piezoelement zugeordneten Transformators 11 angeschlossen sind, an dessen anderes Ende dieses Piezoelement seinerseits angeschlossen ist. Hierbei ist aber weiters vorgesehen, dass die beiden Transistoren 45 und 46, deren Basen das Schaltsignal in Gegenphase von den Ausgängen 22 bzw. 22' der Impulserzeugerstufe 20 her zugeführt wird, beiden Schalteinrichtungen 13 gemeinsam, jeder der beiden Schalteinrichtungen 13 aber separat die beiden Dioden 47 und 48 zugeordnet sind, wobei dann von den hier vorgesehenen vier Dioden 47 bzw. 48 immer die beiden Dioden gleicher Polung je für sich in Serie zum Kollektor des betreffenden Transistors 45 bzw. 46 liegen. Auf diese Weise können die beiden Transistoren 45 und 46 für beide Schalteinrichtungen 13 gemeinsam ausgenützt werden, so dass dann nur mehr die beiden Dioden für jede der beiden Schalteinrichtungen separat vorgesehen sind, was wiederum eine Schaltvereinfachung ergibt.

Hinsichtlich der Funktionsweise verhält sich eine derartige Schaltungsanordnung zur Erzeugung von zwei Steuerspannungen für zwei Piezoelemente vollkommen analog zu der Schaltungsanordnung, wie sie anhand des Ausführungsbeispiels nach Fig. 1 beschrieben wurde. In analoger Weise kann auch eine solche Schaltungsanordnung zur Erzeugung von mehr als zwei Steuerspannungen für mehr als zwei Piezoelemente, die einer entsprechenden Anzahl von Positionierungseinrichtungen angehören, entsprechend erweitert werden.

## Patentansprüche

1. Schaltungsanordnung zur Erzeugung einer Steuerspannung für ein piezoelektrisches Element einer Positionierungseinrichtung, die insbesondere zur Positionierung eines Aufzeichnungs- und/oder Wiedergabekopfes in bezug auf eine Informationsspur vorgesehen ist, bei welcher ein eine Fehlposition widerspiegelndes Regelsignal einer Signalwandlerstufe zugeführt wird, deren Ausgangssignal an den Primärkreis eines Transformators angelegt wird, an dessen Sekundärkreis das piezoelektrische Element über eine bipolare Schalteinrichtung angeschlossen ist, die ihrerseits in vorgegebener Relation zum Ausgangssignal der Signalwandlerstufe mit einem Schaltsignal angesteuert wird, dadurch gekennzeichnet, dass die Signalwandlerstufe als Amplitudenmodulator ausgebildet ist, dem einerseits das eine Fehlposition in seiner Amplitude widerspiegelnde Regelsignal und andererseits von einem Oszillator her ein gegenüber dem Regelsignal höherfrequentes periodisches Trägersignal zugeführt wird, und dass von diesem Trägersignal über eine Impulserzeugerstufe ein periodisches, impulsförmiges, zeitlich jeweils korrespondierend zu nur einem von den beiden Amplitudenspitzenwerten des Trägersignals auftretendes, eine Impulsbreite kleiner als die halbe Periodendauer des Trägersignals aufweisendes Schaltsignal für die Ansteuerung der Schalteinrichtung abgeleitet wird.

2. Schaltungsanordnung nach Anspruch 1, dadurch gekennzeichnet, dass die Signalwandlerstufe als Amplitudenmodulator mit unterdrücktem Träger ausgebildet ist.

3. Schaltungsanordnung nach Anspruch 2, dadurch gekennzeichnet, dass der Amplitudenmodulator als Doppelgegentaktmodulator ausgebildet ist.

4. Schaltungsanordnung nach einem der vorhergehenden Ansprüche, dadurch gekennzeichnet, dass der Transformator für die Frequenz der Grundwelle des Trägersignals auf Parallelresonanz abgestimmt ist.

5. Schaltungsanordnung nach einem der vorhergehenden Ansprüche, dadurch gekennzeichnet, dass der Oszillator als ein ein Sinussignal liefernder Oszillator ausgebildet ist.

6. Schaltungsanordnung nach einem der Ansprüche 1 bis 4, dadurch gekennzeichnet, dass der Oszillator als ein ein Sägezahnsignal liefernder Oszillator ausgebildet ist.

7. Schaltungsanordnung nach Anspruch 6, dadurch gekennzeichnet, dass der Oszillator als ein ein symmetrisches Sägezahnsignal liefernder Oszillator ausgebildet ist.

8. Schaltungsanordnung nach einem der vorhergehenden Ansprüche, dadurch gekennzeichnet, dass die Impulsbreite des Schaltsignals für die Ansteuerung der Schalteinrichtung in der Grössenordnung von einem Zehntel der Periodendauer des Trägersignals gewählt ist.

9. Schaltungsanordnung nach einem der vorhergehenden Ansprüche, dadurch gekennzeichnet, dass zur Erzeugung je einer Steuerspannung für mindestens zwei piezoelektrische Elemente einer entsprechenden Anzahl von Positionierungseinrichtungen jedem der piezoelektrischen Elemente ein Amplitudenmodulator, ein Transformator und eine Schalteinrichtung zugeordnet sind und dass zur Erzeugung eines Trägersignals für alle Amplitudenmodulatoren ein einziger Oszillator und zur Erzeugung eines Schaltsignals für die Ansteuerung aller Schalteinrichtungen eine einzige Impulserzeugerstufe vorgesehen ist.

10. Schaltungsanordnung nach Anspruch 9, bei der eine Schalteinrichtung durch die Parallelschaltung je eines Transistors mit einer in Serie zu seinem Kollektor liegenden Diode gebildet ist, die beiden Transistoren entgegengesetzten Leitfähigkeitstyp aufweisen und die beiden Dioden in Durchlassrichtung zum betreffenden Transistor gepolt und an ein Ende des Sekundärkreises des dem betreffenden piezoelektrischen Element zugeordneten Transformators angeschlossen sind, an dessen anderes Ende dieses piezoelektrische Element seinerseits angeschlossen ist, dadurch gekennzeichnet, dass die beiden Transistoren, deren Basen das Schaltsignal in Gegenphase zugeführt wird, allen Schalteinrichtungen gemeinsam, jeder Schalteinrichtung aber separat die beiden Dioden zugeordnet sind, wobei alle Dioden gleicher Polung je für sich in Serie zum Kollektor des betreffenden Transistors liegen.

11. Schaltungsanordnung nach einem der Ansprüche 1 bis 9, dadurch gekennzeichnet, dass als Schalteinrichtung ein Triac vorgesehen ist, dessen Haltestrom grösser ist als der bei der Steuerung des piezoelektrischen. Elementes maximal durch den Triac fliessende Strom.

12. Schaltungsanordnung nach einem der Ansprüche 1 bis 9, dadurch gekennzeichnet, dass als Schalteinrichtung eine Brückengleichrichterschaltung vorgesehen ist, die mit einer Brückendiagonale zwischen dem Sekundärkreis des Transformators und dem piezoelektrischen Element liegt und in deren andere Brückendiagonale ein vom Schaltsignal angesteuerter Transistor aufgenommen ist.

## Claims

1. A circuit arrangement for generating an actuating voltage for a piezo-electric element of a positioning device, which is intended in particular for positioning a recording and/or reproducing head relative to an information track, a control signal which is representative of a positional error being applied to a signal conversion stage, whose output signal is applied to the primary circuit of a transformer, the piezo-electric element being connected to the secondary circuit of said transformer *via* a bipolar switching device, which in its turn is actuated by a switching signal in a specific relation to the output signal of the signal conversion stage, characterized in that the signal conversion stage in an amplitude modulator, to which the control signal whose amplitude is representative of a positional error is applied and to which a periodic carrier signal from an oscillator is applied, which carrier signal has a higher frequency than the control signal, and a periodic pulse-shaped switching signal for actuating the switching device is derived from said carrier signal by means of a pulse-shaper stage, which switching signal corresponds in time to only one of the two amplitude peak values of the carrier signal and has a pulse width smaller than half the period of the carrier signal.

2. A circuit arrangement as claimed in Claim 1, characterized in that the signal conversion stage is a suppressed-carrier amplitude-modulator.

3. A circuit arrangement as claimed in Claim 2, characterized in that the amplitude modulator is a ring modulator.

4. A circuit arrangement as claimed in any one of the preceding claims, characterized in that the transformer is tuned to parallel resonance for the frequency of the fundamental wave of the carrier signal.

5. A circuit arrangement as claimed in any one of the preceding claims, characterized in that the oscillator is an oscillator which supplies a sine-wave signal.

6. A circuit arrangement as claimed in any one of the Claims 1 to 4, characterized in that the oscillator is an oscillator which supplies a sawtooth signal.

7. A circuit arrangement as claimed in Claim 6, characterized in that the oscillator is an oscillator which supplies a symmetrical sawtooth signal.

8. A circuit arrangement as claimed in any one of the preceding claims, characterized in that the pulse width of the switching signal for actuating the switching device is of the order of magnitude of one tenth of the period of the carrier signal.

9. A circuit arrangement as claimed in any one of the preceding claims, characterized in that for generating an actuating voltage for each of at least two piezo-electric elements of a corresponding number of positioning devices there is provided an amplitude modulator, a transformer and a switching device and for generating a carrier signal for all the amplitude modulators there is provided a single oscillator and for generating a switching signal for the actuation of all the switching devices there is provided a single pulse-shaper stage.

10. A circuit arrangement as claimed in Claim 9, in which each switching device comprises the parallel arrangement of a transistor with a diode connected in series with its collector, the two transistors being of opposite conductivity types and the two diodes being poled in the forward direction relative to the relevant transistor and being connected to one end of the secondary of the transformer associated with the relevant piezo-electric element, which element is connected to the other end of said secondary, characterized in that the two transistors, whose bases receive the switching signal in phase opposition, are common to all the switching devices and two separate diodes are provided for each of the switching devices, all diodes which are poled in the same direction being respectively arranged in series with the collector of the relevant transistor.

11. A circuit arrangement as claimed in any one of the Claims 1 to 9, characterized in that the switching device is a triac whose hold current is larger than the maximum current which flows through the triac when the piezo-electric element is actuated.

12. A circuit arrangement as claimed in any one of the Claims 1 to 9, characterized in that the switching device is a bridge-rectifier circuit of which one diagonal is arranged between the secondary of the transformer and the piezo-electric element and in whose other bridge diagonal a transistor driven by the switching signal is arranged.

## Revendications

1. Circuit de génération d'une tension de commande pour un élément piézo-électrique d'un dispositif de positionnement qui est prévu notamment pour le positionnement d'une tête d'enregistrement et/ou de lecture par rapport à une piste d'information, circuit dans lequel un signal de réglage représentant une erreur de positionnement est appliqué à un étage de conversion de signaux dont le signal de sortie est appliqué au circuit primaire d'un transformateur au circuit secondaire duquel est raccordé l'élément piézo-électrique à travers un dispositif commutateur bipolaire qui, de son côté, est excité par un signal de commutation dans une relation prédéterminée avec le signal de sortie de l'étage de conversion de signaux, caractérisé en ce que l'étage de conversion de signaux est réalisé sous la forme d'un modulateur d'amplitude auquel sont appliqués, d'une part, un signal de réglage dont l'amplitude représente une erreur de positionnement et, d'autre part, un signal porteur périodique ayant une fréquence élevée par rapport au signal de réglage et provenant d'un oscillateur, et en ce qu'à travers un étage générateur d'impulsions est déduit un signal de commutateur périodique en forme d'impulsion pour l'excitation du dispositif commutateur, signal de commutation qui apparaît en synchronisme avec une seule des deux valeurs de crête d'amplitude du signal porteur et qui a une largeur d'impulsion inférieure à la moitié de la période du signal porteur.

2. Circuit selon la revendication 1, caractérisé en ce que l'étage de conversion de signaux est réalisé sous la forme d'un modulateur d'amplitude à porteuse supprimée.

3. Circuit selon la revendication 2, caractérisé en ce que le modulateur d'amplitude est réalisé sous la forme d'un modulateur à anneau.

4. Circuit selon l'une quelconque des revendications précédentes, caractérisé en ce que pour la fréquence de l'onde fondamentale du signal porteur, le transformateur est accordé à la résonance parallèle.

5. Circuit selon l'une quelconque des revendications précédentes, caractérisé en ce que l'oscillateur est réalisé sous la forme d'un oscillateur fournissant un signal sinusoïdal.

6. Circuit selon l'une des revendications 1 à 4, caractérisé en ce que l'oscillateur est réalisé sous la forme d'un oscillateur fournissant un signal en dents de scie.

7. Circuit selon la revendication 6, caractérisé en ce que l'oscillateur est réalisé sous la forme d'un oscillateur fournissant un signal en dents de scie symétrique.

8. Circuit selon l'une quelconque des revendications précédentes, caractérisé en ce que la largeur d'impulsion du signal de commutation pour l'excitation du dispositif commutateur est de l'ordre de grandeur d'un dixième de la période du signal porteur.

9. Circuit selon l'une quelconque des revendications précédentes, caractérisé en ce que, pour la génération d'une tension de commande pour au moins deux éléments piézo-électriques d'un nombre correspondant de dispositifs de positionnement, il est associé à chacun des éléments piézo-électriques un modulateur d'amplitude, un transformateur et un dispositif commutateur et en ce qu'il est prévu un seul oscillateur pour la génération d'un signal porteur pour tous les modulateurs d'amplitude et un seul étage générateur d'impulsions pour la génération d'un signal de commutation pour l'excitation de tous les dispositifs commutateurs.

10. Circuit selon la revendication 9, dans lequel un dispositif commutateur est constitué par le montage parallèle d'un transistor et d'une diode connectée en série avec son collecteur, les deux transistors sont de types de conductivité opposés et les deux diodes sont polarisées dans le sens direct par rapport au transistor concerné et sont raccordés à une extrémité du circuit secondaire du transformateur associé à l'élément piézo-électrique concerné à l'autre extrémité duquel est raccordé ledit élément piézo-électrique, caractérisé en ce que les deux transistors dont les bases reçoivent le signal de commutation en opposition de phase sont communs à tous les dispositifs commutateurs et en ce que les deux diodes sont au contraire associées séparément à chaque dispositif commutateur, toutes les diodes à polarisation

11

identique étant disposées chacune en série avec le collecteur du transistor concerné.

11. Circuit selon l'une quelconque des revendications 1 à 9, caractérisé en ce que le dispositif commutateur est un triac dont le courant de maintien est supérieur au courant maximal qui traverse le triac lors de l'excitation de l'élément piézo-électrique.

12. Circuit selon l'une quelconque des revendications 1 à 9, caractérisé en ce que le dispositif commutateur est un circuit redresseur en pont dont une diagonale de pont est disposée entre le circuit secondaire du transformateur et l'élément piézo-électrique et dans l'autre diagonale de pont duquel est intercalé un transistor excité par le signal de commutation.

12

0 094 712

Fig.1

Fig.2

0 094 712

Fig.3

Fig.4

Fig.5

Fig.6

Fig.7

Fig.8

Fig.9

Fig.10

0 094 712

Fig.11

Fig.12